# EUROPEAN PATENT SPECIFICATION

(11) **EP 3 682 208 B1**
(45) Date of publication and mention of the grant of the patent: **18.08.2021**
(21) Application number: 18762564.5
(22) Date of filing: 21.08.2018
(51) Int. Cl.: G01K 17/00

(54) **A METHOD FOR MANUFACTURING A GRADIENT HEAT-FLUX SENSOR**
VERFAHREN ZUR HERSTELLUNG EINES GRADIENTENWÄRMEFLUSSSENSORS
PROCÉDÉ DE FABRICATION D'UN CAPTEUR DE GRADIENT DE FLUX THERMIQUE

(30) Priority: 12.09.2017 FI 20175806
(43) Date of publication of application: 22.07.2020
(73) Proprietor: Lappeenrannan-Lahden teknillinen yliopisto LUT, 53850 Lappeenranta (FI)
(72) Inventor: KUISMA, Mikko, 53851 Lappeenranta (FI); IMMONEN, Antti, 53851 Lappeenranta (FI); LEVIKARI,Saku, 53851 Lappeenranta (FI)
(74) Representative: Väänänen, Janne Kalervo
(86) International application number: PCT/FI2018/050588
(87) International publication number: WO 2019/053318

(56) References cited:
- US-A- 3 785 875
- HANNE K JUSSILA ET AL: "Local Heat Flux Measurement in a Permanent Magnet Motor at No Load", IEEE TRANSACTIONS ON INDUSTRIAL ELECTRONICS, IEEE SERVICE CENTER, PISCATAWAY, NJ, USA, vol. 60, no. 11, 1 November 2013 (2013-11-01), pages 4852-4860, XP011514251, ISSN: 0278-0046, DOI: 10.1109/TIE.2012.2222853 cited in the application
- ANDREY V MITYAKOV ET AL: "Gradient heat flux sensors for high temperature environments", SENSORS AND ACTUATORS A: PHYSICAL, ELSEVIER BV, NL, vol. 176, 9 December 2011 (2011-12-09), pages 1-9, XP028461297, ISSN: 0924-4247, DOI: 10.1016/J.SNA.2011.12.020 [retrieved on 2012-01-17]
- Huynh Tho ET AL: "Fabrication and Characterization of a Multichannel 3D Thermopile for Chip Calorimeter Applications", Sensors, vol. 15, no. 2, 3 February 2015 (2015-02-03), pages 3351-3361, XP055777194, DOI: 10.3390/s150203351 Retrieved from the Internet: URL:https://www.ncbi.nlm.nih.gov/pmc/artic les/PMC4367362/pdf/sensors-15-03351.pdf>

## Description

### Technical field

The disclosure relates generally to gradient heat-flux sensors "GHFS" for measuring thermal energy transfer directly. More particularly, the disclosure relates to a method for manufacturing a gradient heat-flux sensor.

### Background

Heat-flux sensors are used in various power-engineering applications where local heat-flux measurements can be more important than temperature measurements. A heat-flux sensor can be based on multiple thermoelectric junctions so that tens, hundreds, or even thousands of thermoelectric junctions are connected in series. For another example, a heat-flux sensor can be based on one or more anisotropic elements where thermal electromotive force is created from a heat-flux by the Seebeck effect. Because of the anisotropy, a temperature gradient has components in two directions: along and across to a heat-flux through the sensor. Electromotive force is generated proportional to the temperature gradient component across to the heat-flux. The heat-flux sensor is called a gradient heat-flux sensor "GHFS" because it generates an electric output signal proportional to the above-mentioned temperature gradient component across to the heat-flux. The anisotropy can be implemented with suitable anisotropic material such as for example single-crystal bismuth. A drawback of gradient heat-flux sensors based on single-crystal bismuth is that they are not suitable for heat-flux measurements in high temperatures because of the low melting point of bismuth.

Another option for implementing the anisotropy is a multilayer structure where layers are oblique with respect to a surface of a gradient heat-flux sensor for receiving a heat-flux. The multilayer structure may comprise first layers and second layers so that the second layers are interleaved with the first layers. The first layers can be made of for example semiconductor material, and the second layers can be made of for example metal or metal alloy or of semiconductor material different from the semiconductor material of the first layers. An upper limit of operating temperature of a gradient heat-flux sensor based on a multilayer structure can be significantly higher than that of a heat-flux sensor based on bismuth. Further details of gradient heat-flux sensors based on a multilayer structure can be found from for example the publication: *"*Local Heat Flux Measurement in a Permanent Magnet Motor at No Load", Hanne K. Jussila, Andrey V. Mityakov, Sergey Z. Sapozhnikov, Vladimir Y. Mityakov and Juha Pyrhönen, Institute of Electrical and Electronics Engineers "IEEE" Transactions on Industrial Electronics, Volume: 60, pp. 4852 - 4860, 2013. Gradient heat-flux sensors based on a multilayer structure of the kind described above are, however, not free from challenges. One of the challenges is related to manufacturing processes which are typically difficult to adapt for mass-production. Thus, the unit price of gradient heat-flux sensors based on a multilayer structure can be high. The high unit price, in turn, limits the use of gradient heat-flux sensors in mass-produced products.

Another example of gradient heat-flux sensor can be found in Huynh Tho ET AL: "Fabrication and Characterization of a Multichannel 3D Thermopile for Chip Calorimeter Applications",Sensors, vol. 15, no. 2, 3 February 2015 (2015-02-03), pages 3351-3361. This document describes a Ni/Au thermocouple array on an alkaline etched Si substrate. The fabrication process of the Ni/Au thermocouple array follows the phases illustrated on figure 1 of said document, where a surface of a silicon wafer is oxidized, a pattern is created on the oxide to form etching windows, part of the silicon wafer is etched away, the remaining oxide is removed, a layer of Ni is deposited according to a pattern and a layer of Au is deposited according to a second pattern.

### Summary

The following presents a simplified summary in order to provide a basic understanding of some aspects of various invention embodiments. The summary is not an extensive overview of the invention. It is neither intended to identify key or critical elements of the invention nor to delineate the scope of the invention. The following summary merely presents some concepts of the invention in a simplified form as a prelude to a more detailed description of exemplifying embodiments of the invention.

In this document, the word "geometric" when used as a prefix means a geometric concept that is not necessarily a part of any physical object. The geometric concept can be for example a geometric point, a straight or curved geometric line, a geometric plane, a non-planar geometric surface, a geometric space, or any other geometric entity that is zero, one, two, or three dimensional.

In accordance with the invention, there is provided a new method for manufacturing a gradient heat-flux sensor based on a multilayer structure where layers are oblique with respect to a surface of the gradient heat-flux sensor for receiving a heat-flux. A method according to the invention comprises:
- depositing a semiconductor layer on a planar surface,
- removing material from the semiconductor layer so that mutually parallel semiconductor ridges are formed, the semiconductor ridges being separate from each other and having first sidewalls being slanting with respect to the planar surface and facing towards a first direction and second sidewalls facing towards a second direction different from the first direction, and subsequently
- filling gaps between adjacent ones of the semiconductor ridges with one or more materials comprising metal so that i) metal-semiconductor contact junctions are formed on at least the first sidewalls of the semiconductor ridges and ii) gap-fillers constituted by the one or more materials and located in different ones of the gaps are separate from each other so that the metals of the gap-fillers located in different ones of the gaps are free from metallic contacts between each other.

The above-mentioned semiconductor ridges and the gap-fillers constitute an anisotropic metal-semiconductor multilayer structure for forming electromotive force in a direction perpendicular to the semiconductor ridges and parallel with the above-mentioned planar surface in response to a heat-flux through the anisotropic structure in a direction perpendicular to the planar surface. The anisotropic metal-semiconductor multilayer structure can be used as also a thermoelement which transfers heat from its first side to its second side in the direction perpendicular to the planar surface when electric current is driven through it in the direction perpendicular to the semiconductor ridges and parallel with the planar surface.

In a method according to an exemplifying and non-limiting embodiment of the invention, the above-mentioned gap-fillers are formed by:
- depositing metal layers on the first sidewalls of the semiconductor ridges whilst leaving the second sidewalls uncovered so that the metal layers are separate from each other, and subsequently
- filling the gaps with semiconductor material constituting semiconductor fillers so that the semiconductor fillers located in different ones of gaps are separate from each other.

The method phases of the above-described method are similar to for example method phases of existing methods for fabricating integrated circuits "IC". Thus, the method is suitable for mass-production.

The semiconductor ridges can be formed for example with a wet etching technique which produces the slanting sidewalls of the semiconductor ridges. It is, however, also possible to use other methods for removing material from the semiconductor layer so that the slanting sidewalls of the semiconductor ridges are formed. Thus, the above-described method utilizes the inherent property of such material removal techniques, e.g. wet etching, which produce non-vertical, i.e. slanting, sidewalls of grooves and cavities. In this document, the term 'vertical' means a direction that is perpendicular to the planar surface on which the semiconductor layer is deposited.

Various exemplifying and non-limiting embodiments of the invention are described in accompanied dependent claims.

Various exemplifying and non-limiting embodiments of the invention both as to constructions and to methods of operation, together with additional objects and advantages thereof, will be best understood from the following description of specific exemplifying and non-limiting embodiments when read in conjunction with the accompanying drawings.

The verbs "to comprise" and "to include" are used in this document as open limitations that neither exclude nor require the existence of unrecited features. The features recited in dependent claims are mutually freely combinable unless otherwise explicitly stated. Furthermore, it is to be understood that the use of "a" or "an", i.e. a singular form, throughout this document does not exclude a plurality.

### Brief description of the figures

Exemplifying and non-limiting embodiments of the invention and their advantages are explained in greater detail below in the sense of examples and with reference to the accompanying drawings, in which:
figure 1 shows a flowchart of a method according to an exemplifying and non-limiting embodiment of the invention for manufacturing a gradient heat-flux sensor,
figures 2a, 2b, 2c, 2d, 2e and 2f illustrate successive manufacturing stages of a gradient heat-flux sensor manufactured by a method according to an exemplifying and non-limiting embodiment of the invention,
figure 3 illustrates a structure of a gradient heat-flux sensor manufactured by a method according to an exemplifying and non-limiting embodiment of the invention,
figure 4 illustrates a structure of a gradient heat-flux sensor manufactured by a method according to an exemplifying and non-limiting embodiment of the invention,
figure 5 illustrates a structure of a gradient heat-flux sensor manufactured by a method according to an exemplifying and non-limiting embodiment of the invention,
figure 6 illustrates a structure of a gradient heat-flux sensor manufactured by a method according to an exemplifying and non-limiting embodiment of the invention, and
figure 7 illustrates a structure of a gradient heat-flux sensor manufactured by a method according to an exemplifying and non-limiting embodiment of the invention.

### Description of the exemplifying embodiments

The specific examples provided in the description below should not be construed as limiting the scope and/or the applicability of the accompanied claims. Lists and groups of examples provided in the description are not exhaustive unless otherwise explicitly stated.

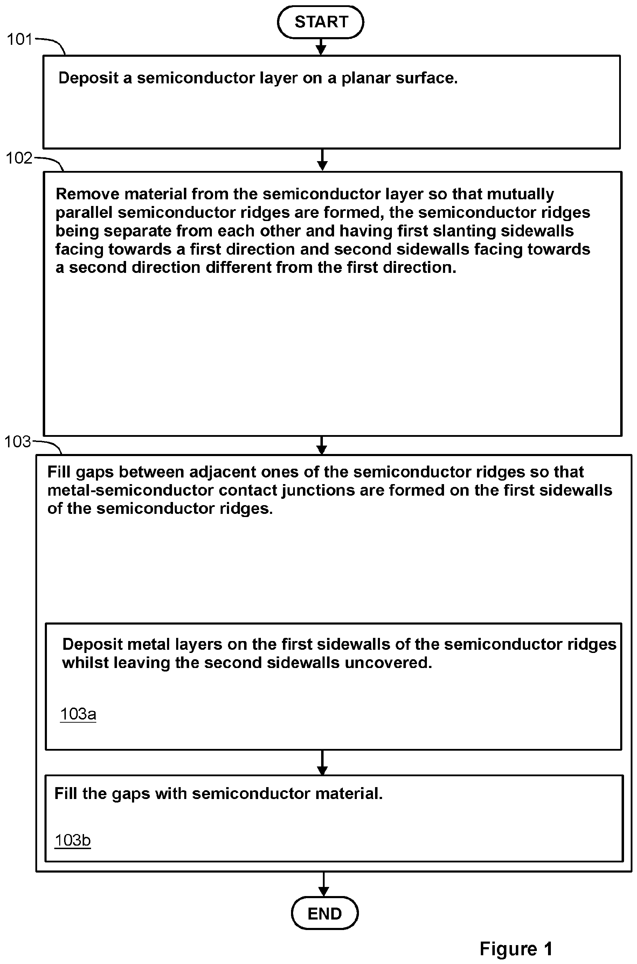

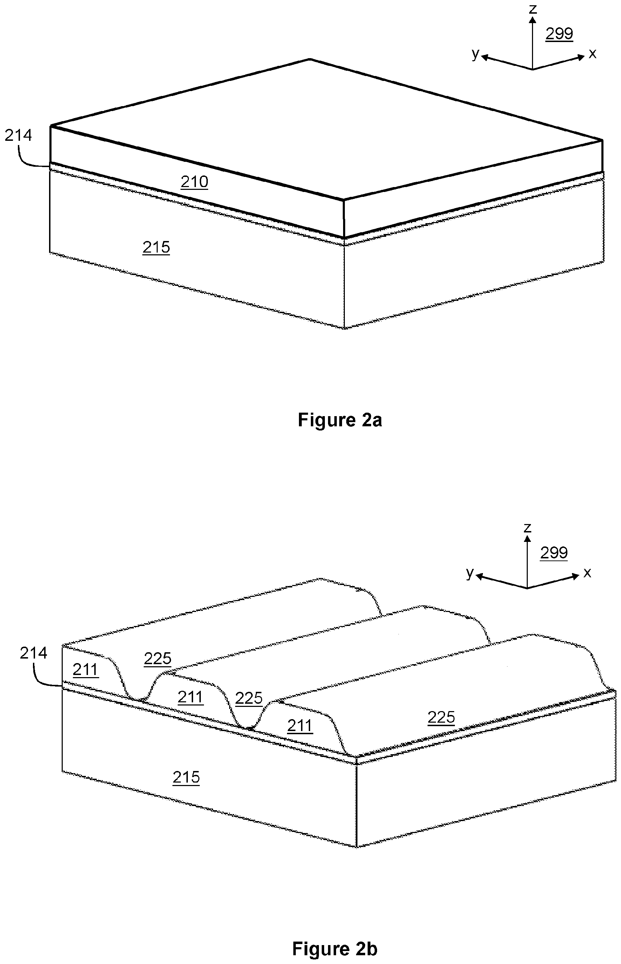

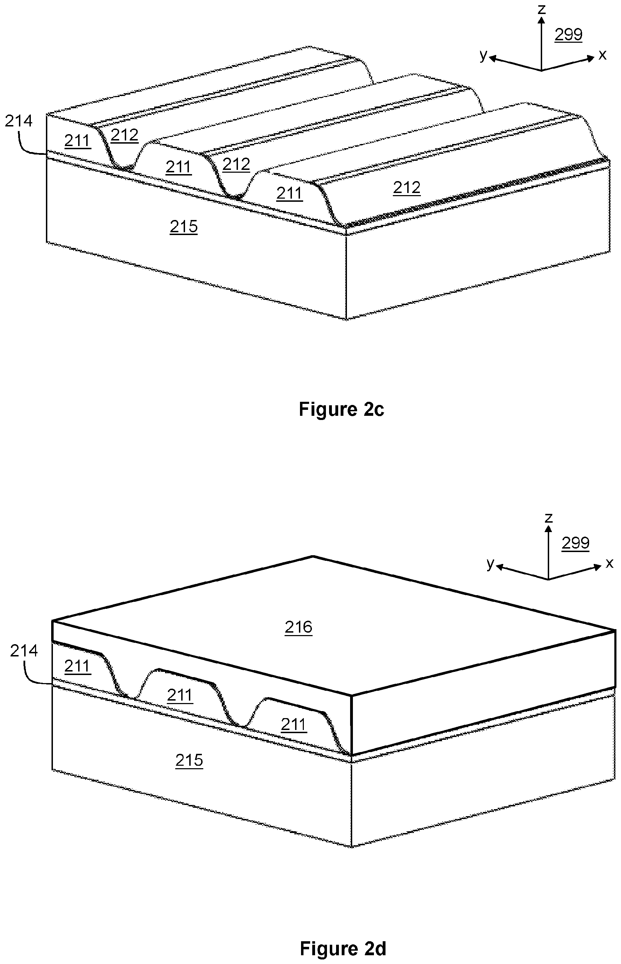

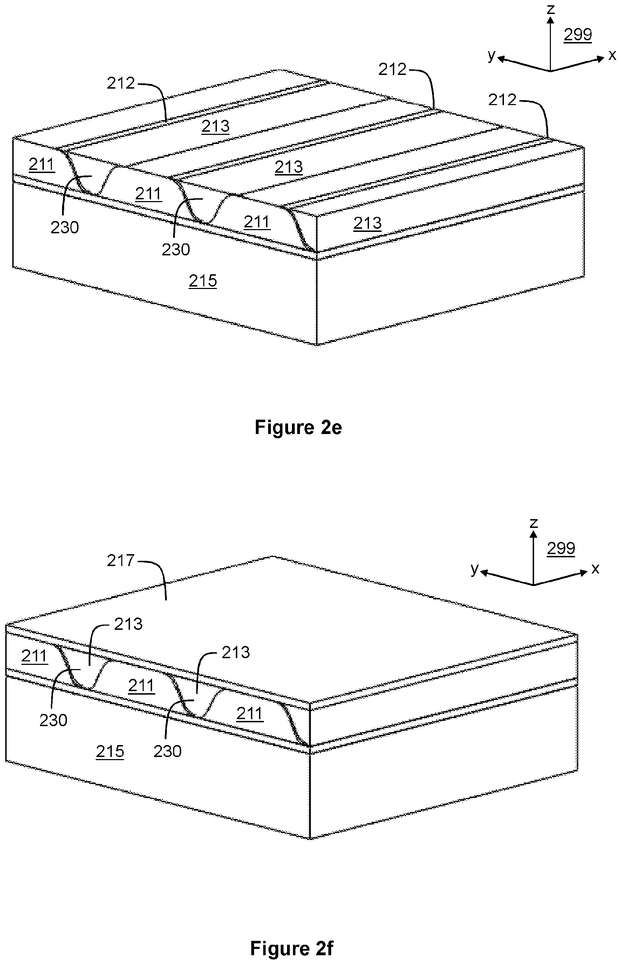

Figure 1 shows a flowchart of a method according to an exemplifying and non-limiting embodiment of the invention for manufacturing a gradient heat-flux sensor. Figures 2a, 2b, 2c, 2d, 2e and 2f illustrate successive manufacturing stages of the gradient heat-flux sensor. In phase 101 shown in figure 1, the method comprises depositing a semiconductor layer on a planar surface. In figure 2a, the semiconductor layer is denoted with a reference 210. The material of the semiconductor layer 210 can be for example n-doped or p-doped silicon. In this exemplifying case, an electrically insulating layer 214 is deposited on a substrate 215 and thereafter the semiconductor layer 210 is deposited on the electrically insulating layer. Depending on the materials of the substrate 215 and the semiconductor layer 210, it is also possible that the semiconductor layer 210 is deposited directly on the substrate 215.

In phase 102 shown in figure 1, the method comprises removing material from the semiconductor layer 210 so that mutually parallel semiconductor ridges are formed. In figures 2b-2f, the semiconductor ridges are denoted with a reference 211. As illustrated in figure 2b, the semiconductor ridges 211 have first slanting sidewalls facing towards a first direction and second sidewalls facing towards a second direction different from the first direction. In figure 2b, the first slanting sidewalls are denoted with a reference 225. As shown in figure 2b, the slanting sidewalls 225 of the semiconductor ridges 211 are oblique with respect to the vertical xz-plane of a coordinate system 299, i.e. with respect to a vertical geometric plane that is perpendicular to the planar surface of the electrically insulating layer 214 and parallel with the longitudinal direction of the semiconductor ridges 211.

Grooves made on the structure shown in figure 2a for forming the above-mentioned semiconductor ridges 211 are so deep that the semiconductor ridges 211 are separate from each other. The semiconductor ridges 211 can be formed using for example a wet etching technique. The wet etching can be for example isotropic wet etching which provides rounded edges of the semiconductor ridges such as illustrated in figures 2b-2f. The isotropic wet etching can be based on e.g. hydrogen fluoride acid, nitric acid, or acetic acid. In cases where the semiconductor layer 210 has a suitable crystal structure e.g. <100>, the semiconductor ridges 211 can be formed using anisotropic wet etching which provides slanted sidewalls that are more planar than those formed with isotropic wet etching. It is also possible that the semiconductor ridges 211 are formed with anisotropic dry etching directed to provide slanting sidewalls, e.g. a skewed DRIE-process, where DRIE means Deep Reactive-Ion Etching.

In phase 103 shown in figure 1, the method comprises filling gaps between adjacent ones of the semiconductor ridges so that metal-semiconductor contact junctions are formed on the above-mentioned first sidewalls of the semiconductor ridges. The gaps are filled so that gap-fillers formed into the gaps are separate from each other. In figures 2e and 2f, the gap-fillers are denoted with a reference 230. The gap-fillers 230 are separate from each other because contacts between the gap-fillers 230 would disturb or even prevent the operation of the gradient heat-flux sensor because they would at least partly short-circuit the electromotive forces created from a heat-flux by the Seebeck effect.

In the exemplifying case illustrated in figure 1 and in figures 2a-2f, the phase 103 for filling the gaps comprises sub-phases 103a and 103b. The sub-phase 103a comprises depositing metal layers on the above-mentioned first sidewalls of the semiconductor ridges whilst leaving the above-mentioned second sidewalls uncovered. In figure 2c, the metal layers are denoted with a reference 212. As illustrated in figure 2c, the metal layers are separate from each other. The metal layers can be made of for example aluminum, copper, molybdenum, constantan, nichrome, or some other suitable metal. The sub-phase 103b comprises filling gaps between adjacent ones of the semiconductor ridges with semiconductor material so that the semiconductor material filling the gaps constitutes semiconductor fillers that are separate from each other. In figure 2e, the semiconductor fillers are denoted with a reference 213. The semiconductor fillers 213 are advantageously same material as the semiconductor ridges 211, or material with properties of electrical conductivity and Seebeck coefficient similar to those of the material of the semiconductor ridges 211. The material of the semiconductor fillers 213 can be for example n-doped or n-doped silicon. The semiconductor fillers 213 can be made of epitaxial silicon or polycrystalline silicon. In the exemplifying case illustrated in figures 2a-2f, the semiconductor fillers 213 are formed by depositing a semiconductor layer on the structure comprising the semiconductor ridges 211 and the metal layers 212, and subsequently removing material from the semiconductor layer. In figure 2d, the above-mentioned semiconductor layer is denoted with a reference 216. The above-mentioned semiconductor ridges 211, the metal layers 212, and the semiconductor fillers 213 constitute an anisotropic metal-semiconductor multilayer structure for forming electromotive force in a direction parallel with the y-axis of the coordinate system 299 in response to a heat-flux through the anisotropic structure in a direction parallel with the z-axis of the coordinate system 299.

In a method according to an exemplifying and non-limiting embodiment of the invention, the semiconductor layer 216 and thereby the semiconductor fillers 213 are shorter than the semiconductor ridges 211 in the longitudinal direction of the semiconductor ridges, i.e. in the x-direction of the coordinate system 299, so that end-regions of the gaps remain unfilled. This approach is advantageous in cases where there would be a risk that adjacent semiconductor fillers 213 would get, due to processual non-idealities, in contact with each other on the end-regions of the semiconductor ridges if the semiconductor layer 216 were deposited to fully cover the structure comprising the semiconductor ridges 211 and the metal layers 212. Unwanted contacts between the semiconductor fillers 213 would disturb or even prevent the operation of the gradient heat-flux sensor because they would at least partly short-circuit the electromotive forces created from a heat-flux by the Seebeck effect. Other methods for avoiding unwanted contacts, such as trench isolation or structures of insulating material, are also possible. Furthermore, a dedicated mask pattern and a subsequent etching phase can also be implemented to remove excess semiconductor filler material.

A method according to an exemplifying and non-limiting embodiment of the invention further comprises depositing an electrically insulating layer on top of a structure comprising the semiconductor ridges 211, the metal layers 212, and the semiconductor fillers 213. In figure 2f, the above-mentioned electrically insulating layer is denoted with a reference 217.

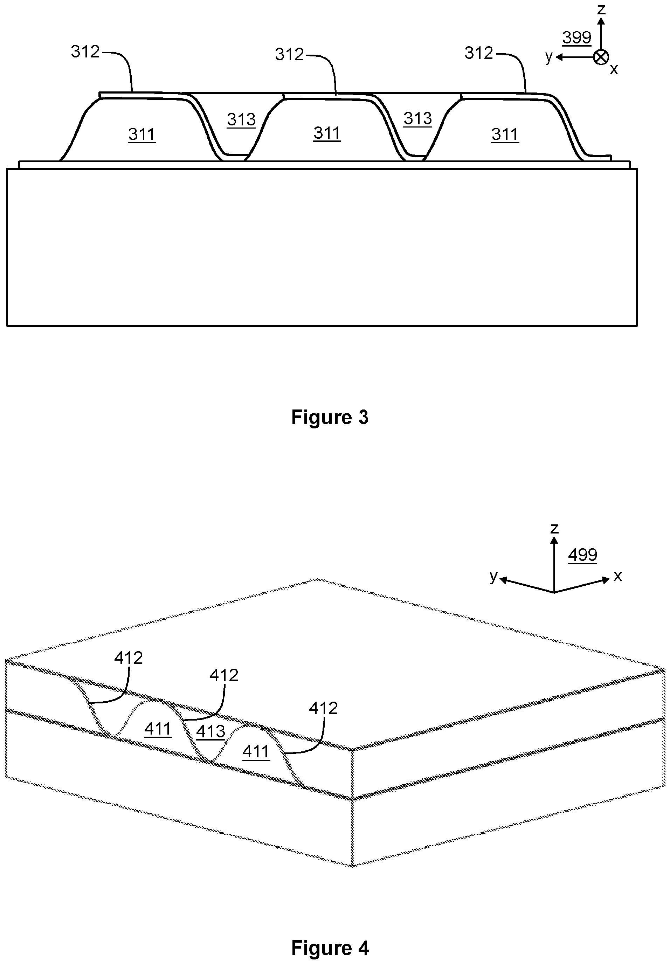

Figure 3 illustrates a structure of a gradient heat-flux sensor manufactured by a method according to an exemplifying and non-limiting embodiment of the invention. In this exemplifying case, each of the metal layers 312 is deposited on one sidewall of a respective one of the semiconductor ridges 311 and on a substantially flat top surface of the semiconductor ridge under consideration. Furthermore, the metal layer 312 of each semiconductor ridge is in contact with a base of a neighboring semiconductor ridge. The gaps between adjacent ones of the semiconductor ridges 311 are filled with semiconductor fillers 313 as illustrated in figure 3.

Figure 4 illustrates a structure of a gradient heat-flux sensor manufactured by a method according to an exemplifying and non-limiting embodiment of the invention. The gradient heat-flux sensor comprises, among others, semiconductor ridges 411, metal layers 412 covering one slanting sidewall of each semiconductor ridge, and semiconductor fillers 413 between adjacent ones of the semiconductor ridges. The structure of the gradient heat-flux sensor illustrated in figure 4 is otherwise similar to the structure illustrated in figure 2f but the semiconductor ridges 411 have a cross-sectional profile that is more round-shaped than the cross-sectional profile of the semiconductor ridges 211 illustrated in figure 2f. In gradient heat-flux sensors according to different embodiments of the invention, the cross-sectional profile of the semiconductor ridges can have a shape of a triangle, a trapezoid, a modified trapezoid having curved sides as shown in figures 2b-2f and 3, a bell curve as shown in figure 4, or another shape providing slanting sidewalls and implementable with a suitable material removal process such as e.g. wet etching.

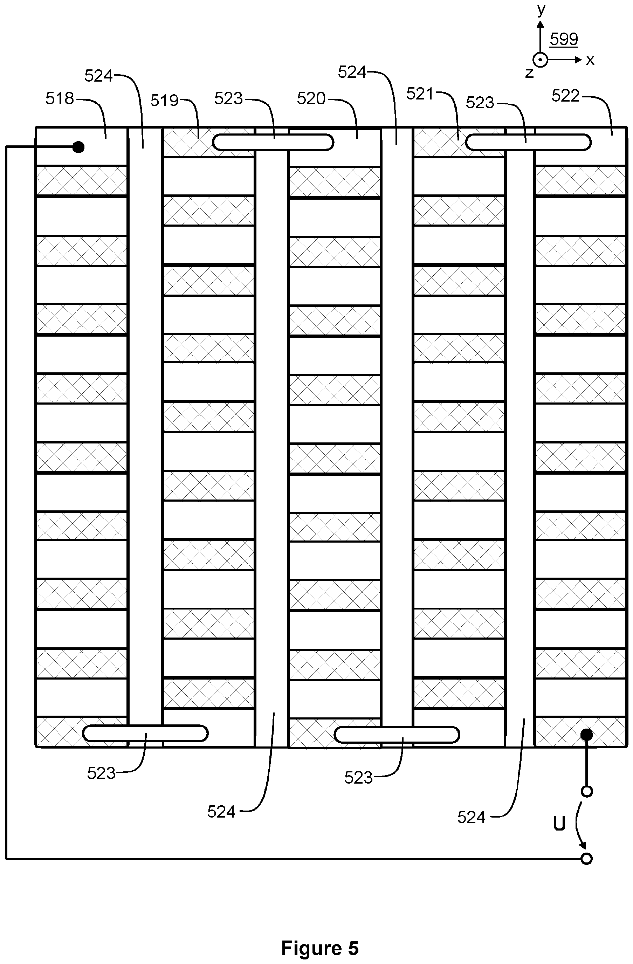

Figure 5 illustrates a gradient heat-flux sensor manufactured by a method according to an exemplifying and non-limiting embodiment of the invention. In this exemplifying case, the method comprises constructing, on a same substrate, many anisotropic multilayer structures 518, 519, 520, 521, and 522 for forming electromotive forces in response to heat-fluxes through the anisotropic multilayer structures 518-522 in a direction parallel with the z-axis of a coordinate system 599. In this exemplifying case, the method further comprises connecting the anisotropic multilayer structures 518-522 electrically in series so that voltage U is indicative of the total heat-flux through the anisotropic multilayer structures 518-522. The anisotropic multilayer structures 518-522 are connected in series with the aid of electrical connectors 523. It is also possible that anisotropic multilayer structures of the kind mentioned above are electrically connected in parallel or in mixed connections where e.g. groups of series connected anisotropic multilayer structures are connected in parallel or groups of parallel connected anisotropic multilayer structures are connected in series. The semiconductor ridges of the anisotropic multilayer structures 518-522 can be made by forming mutually parallel first grooves having slanting sidewalls and then by forming mutually parallel second grooves 524 perpendicular to the first grooves so as to separate adjacent ones of the anisotropic multilayer structures from each other. In figure 5, the first grooves and thereby the semiconductor ridges are parallel with the x-direction of the coordinate system 599 and the second grooves are parallel with the y-direction of the coordinate system 599. In figure 5, the crosshatched areas indicate the locations of the metal layers deposited on the appropriate slanting sidewalls of the semiconductor ridges.

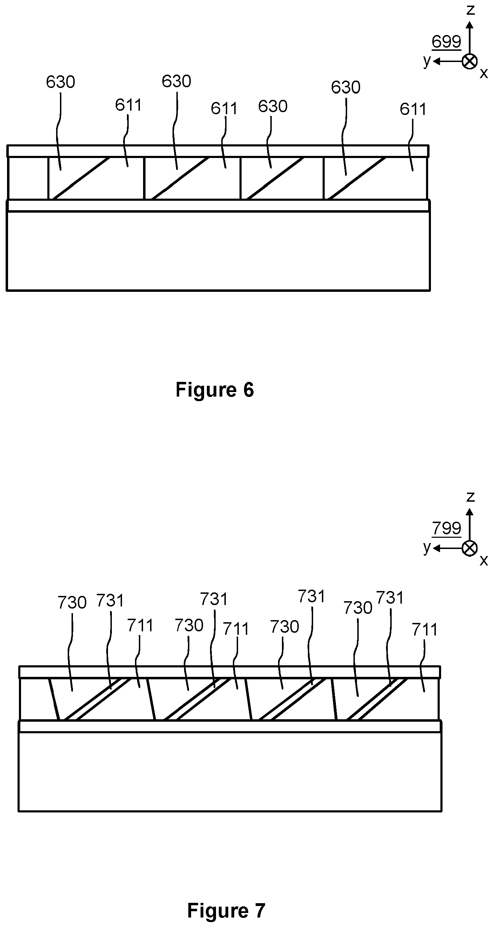

Figure 6 illustrates a structure of a gradient heat-flux sensor manufactured by a method according to an exemplifying and non-limiting embodiment of the invention. The gradient heat-flux sensor comprises, among others, semiconductor ridges 611 and gap-fillers 630 between the semiconductor ridges 611. In this exemplifying case, the first sidewalls of the semiconductor ridges 611 are slanting but the second sidewalls are substantially perpendicular to the planar surface onto which the semiconductor ridges 611 are formed, i.e. the second sidewalls of the semiconductor ridges 611 are substantially parallel with the xz-plane of a coordinate system 699. The gap-fillers 630 are formed by filling the gaps between the semiconductor ridges 611 with metal that can be e.g. aluminum, copper, molybdenum, constantan, nichrome, or some other suitable metal. Because of the slanting metal-semiconductor contact junctions on the first sidewalls of the semiconductor ridges, electromotive force is produced in a direction parallel with the y-axis of the coordinate system 699 in response to a heat-flux penetrating the gradient heat-flux sensor in a direction parallel with the z-axis of the coordinate system 699. As the second sidewalls are substantively vertical, an opposite electromotive force produced at the metal-semiconductor contact junctions on the second sidewalls is small and thus the opposite electromotive force does not cancel the electromotive force produced at the metal-semiconductor contact junctions on the first sidewalls.

Figure 7 illustrates a structure of a gradient heat-flux sensor manufactured by a method according to an exemplifying and non-limiting embodiment of the invention. The gradient heat-flux sensor comprises, among others, semiconductor ridges 711 and gap-fillers 730 between the semiconductor ridges 711. In this exemplifying case, the gap-fillers 730 are formed by depositing layers 731 of first metal on the first sidewalls of the semiconductor ridges 711 whilst leaving the second sidewalls uncovered and then filling the gaps between the layers of the first metal and the second sidewalls with second metal different from the first metal. The first metal can be e.g. aluminum, copper, molybdenum, constantan, nichrome, or some other suitable metal. The second metal can be e.g. copper, molybdenum, constantan, nichrome, aluminum or some other suitable metal different from the first metal. The material of the semiconductor ridges, the first metal, and the second metal are selected so that a net electromotive force is produced in a direction parallel with the y-axis of a coordinate system 799 in response to a heat-flux penetrating the gradient heat-flux sensor in a direction parallel with the z-axis of the coordinate system 799.

The specific examples provided in the description given above should not be construed as limiting the applicability and/or interpretation of the appended claims. It is to be noted that lists and groups of examples given in this document are non-exhaustive lists and groups unless otherwise explicitly stated.

## Claims

1. A method for manufacturing a gradient heat-flux sensor, **characterized in that** the method comprises:
- depositing (101) a semiconductor layer (210) on a planar surface,
- removing (102) material from the semiconductor layer so that mutually parallel semiconductor ridges (211, 311, 411, 611, 711) are formed, the semiconductor ridges being separate from each other and having first sidewalls being slanting with respect to the planar surface and facing towards a first direction and second sidewalls facing towards a second direction different from the first direction, and subsequently
- filling (103) gaps between adjacent ones of the semiconductor ridges with one or more materials comprising metal so that i) metal-semiconductor contact junctions are formed on at least the first sidewalls of the semiconductor ridges and ii) gap-fillers (230, 630, 730) constituted by the one or more materials and located in different ones of the gaps are separate from each other so that the metals of the gap-fillers located in different ones of the gaps are free from metallic contacts between each other,
wherein the semiconductor ridges and the gap-fillers constitute an anisotropic multilayer structure for forming electromotive force in a direction perpendicular to the semiconductor ridges and parallel with the planar surface in response to a heat-flux through the anisotropic multilayer structure in a direction perpendicular to the planar surface.

2. A method according to claim 1, wherein the semiconductor layer is deposited on a substrate having the planar surface.

3. A method according to claim 1, wherein the method comprises depositing an electrically insulating layer (214) on a substrate (215), and the semiconductor layer is deposited on the electrically insulating layer having the planar surface.

4. A method according to any of claims 1-3, wherein the method further comprises depositing an electrically insulating layer (217) on top of the anisotropic multilayer structure.

5. A method according to any of claims 1-4, wherein the gap-fillers (230) are formed by:
- depositing (103a) metal layers (212, 312, 412) on the first sidewalls of the semiconductor ridges whilst leaving the second sidewalls uncovered, the metal layers being separate from each other, and subsequently
- filling (103b) the gaps with semiconductor material constituting semiconductor fillers (213) so that the semiconductor fillers located in different ones of gaps are separate from each other.

6. A method according to claim 5, wherein the semiconductor fillers (213) are formed by depositing a layer (216) of the semiconductor material on a structure comprising the semiconductor ridges and the metal layers and by removing material from the layer of the semiconductor material.

7. A method according to claim 5 or 6, wherein the semiconductor ridges (311) have substantially flat top surfaces, and the metal layers (312) are deposited to cover the first sidewalls of the semiconductor ridges and at least partly the substantially flat top surfaces of the semiconductor ridges.

8. A method according to any of claims 5-7, wherein the metal layer (312) of each semiconductor ridge is deposited to be in contact with a base of a neighboring semiconductor ridge.

9. A method according to any of claims 5-8, wherein the semiconductor ridges are formed by removing material from the semiconductor layer with a wet etching technique.

10. A method according to any of claims 5-9, wherein:
- the metal layers are made of one of the following metals: aluminum, copper, molybdenum, constantan, nichrome,
- the semiconductor fillers are made of n-doped silicon or p-doped silicon or epitaxial silicon or polycrystalline silicon, and
- the semiconductor ridges are made of n-doped silicon or p-doped silicon.

11. A method according to any of claims 5-10, wherein the semiconductor ridges and the semiconductor fillers are made of same material.

12. A method according to any of claims 1-3, wherein the second sidewalls of the semiconductor ridges (611) are substantially perpendicular to the planar surface, and the gap-fillers (630) are formed by filling the gaps between adjacent ones of the semiconductor ridges with metal.

13. A method according to any of claims 1-3, wherein the gap-fillers (730) are formed by depositing layers (731) of first metal on the first sidewalls of the semiconductor ridges (711) whilst leaving the second sidewalls uncovered and then filling the gaps between the layers of the first metal and the second sidewalls with second metal different from the first metal.

14. A method according to any of claims 1-13, wherein the method comprises constructing, on a same substrate, at least two anisotropic multilayer structures (518-522) for forming electromotive forces, and connecting the at least two anisotropic multilayer structures electrically to each other.

15. A method according to claim 14, wherein the semiconductor ridges of the at least two anisotropic multilayer structures (518-522) are made by forming mutually parallel first grooves having slanting sidewalls and by forming mutually parallel second grooves (524) perpendicular to the first grooves, the second grooves separating adjacent ones of the anisotropic multilayer structures from each other.

## Patentansprüche

1. Verfahren zur Herstellung eines Gradienten-Wärmeflusssensors, **dadurch gekennzeichnet, dass** das Verfahren umfasst:
- Abscheiden (101) einer Halbleiterschicht (210) auf einer ebenen Oberfläche,
- Entfernen (102) von Material aus der Halbleiterschicht, sodass zueinander parallele Halbleiterrippen (211, 311, 411, 611, 711) ausgebildet werden, wobei die Halbleiterrippen voneinander getrennt sind und erste Seitenwände, die in Bezug auf die ebene Oberfläche schräg sind und in eine erste Richtung weisen, und zweite Seitenwände, die in eine zweite Richtung weisen, die von der ersten Richtung verschieden ist, aufweisen, und nachfolgend
- Füllen (103) von Spalten zwischen benachbarten der Halbleiterrippen mit einem oder mehreren Materialien, die Metall umfassen, sodass i) an wenigstens den ersten Seitenwänden der Halbleiterrippen Metall-Halbleiter-Kontakt-Verbindungsstellen ausgebildet werden und ii) Spaltfüllstoffe (230, 630, 730), die durch das eine oder die mehreren Materialien gebildet werden und sich in verschiedenen der Spalte befinden, voneinander getrennt sind, sodass die Metalle der Spaltfüllstoffe, die sich in verschiedenen der Spalte befinden, frei von metallischen Kontakten untereinander sind,
wobei die Halbleiterrippen und die Spaltfüllstoffe eine anisotrope mehrschichtige Struktur bilden, zum Ausbilden elektromotorischer Kraft in einer Richtung senkrecht zu den Halbleiterrippen und parallel zu der ebenen Oberfläche als Reaktion auf einen Wärmefluss durch die anisotrope mehrschichtige Struktur in einer Richtung senkrecht zu der ebenen Oberfläche.

2. Verfahren nach Anspruch 1, wobei die Halbleiterschicht auf einem Substrat abgeschieden wird, das die ebene Oberfläche aufweist.

3. Verfahren nach Anspruch 1, wobei das Verfahren ein Abscheiden einer elektrisch isolierenden Schicht (214) auf einem Substrat (215) umfasst und die Halbleiterschicht auf der elektrisch isolierenden Schicht, welche die ebene Oberfläche aufweist, abgeschieden wird.

4. Verfahren nach einem der Ansprüche 1 - 3, wobei das Verfahren ferner ein Abscheiden einer elektrisch isolierenden Schicht (217) auf der Oberseite der anisotropen mehrschichtigen Struktur umfasst.

5. Verfahren nach einem der Ansprüche 1 - 4, wobei die Spaltfüllstoffe (230) ausgebildet werden durch:
- Abscheiden (103a) von Metallschichten (212, 312, 412) auf den ersten Seitenwänden der Halbleiterrippen, während die zweiten Seitenwände unbedeckt belassen werden, wobei die Metallschichten voneinander getrennt sind, und nachfolgend
- Füllen (103b) der Spalte mit Halbleitermaterial, das Halbleiterfüllstoffe (213) bildet, sodass die Halbleiterfüllstoffe, die sich in verschiedenen der Spalte befinden, voneinander getrennt sind.

6. Verfahren nach Anspruch 5, wobei die Halbleiterfüllstoffe (213) durch Abscheiden einer Schicht (216) des Halbleitermaterials auf einer Struktur, welche die Halbleiterrippen und die Metallschichten umfasst, und durch Entfernen von Material aus der Schicht des Halbleitermaterials ausgebildet werden.

7. Verfahren nach Anspruch 5 oder 6, wobei die Halbleiterrippen (311) im Wesentlichen flache Oberseitenflächen aufweisen und die Metallschichten (312) so abgeschieden werden, dass sie die ersten Seitenwände der Halbleiterrippen und wenigstens teilweise die im Wesentlichen flachen Oberseitenflächen der Halbleiterrippen bedecken.

8. Verfahren nach einem der Ansprüche 5 - 7, wobei die Metallschicht (312) jeder Halbleiterrippe so abgeschieden wird, dass sie mit einer Basis einer benachbarten Halbleiterrippe in Kontakt steht.

9. Verfahren nach einem der Ansprüche 5 - 8, wobei die Halbleiterrippen durch Entfernen von Material aus der Halbleiterschicht mit einer Nassätztechnik ausgebildet werden.

10. Verfahren nach einem der Ansprüche 5 - 9, wobei:
- die Metallschichten aus einem der folgenden Metalle hergestellt sind: Aluminium, Kupfer, Molybdän, Konstantan, Nichrom,
- die Halbleiterfüllstoffe aus n-dotiertem Silicium oder p-dotiertem Silicium oder epitaktischem Silicium oder polykristallinem Silicium hergestellt sind, und
- die Halbleiterrippen aus n-dotiertem Silicium oder p-dotiertem Silicium hergestellt sind.

11. Verfahren nach einem der Ansprüche 5 - 10, wobei die Halbleiterrippen und die Halbleiterfüllstoffe aus dem gleichen Material hergestellt sind.

12. Verfahren nach einem der Ansprüche 1 - 3, wobei die zweiten Seitenwände der Halbleiterrippen (611) im Wesentlichen senkrecht zu der ebenen Oberfläche sind und die Spaltfüllstoffe (630) durch Füllen der Spalte zwischen benachbarten der Halbleiterrippen mit Metall ausgebildet werden.

13. Verfahren nach einem der Ansprüche 1 - 3, wobei die Spaltfüllstoffe (730) durch Abscheiden von Schichten (731) eines ersten Metalls auf den ersten Seitenwänden der Halbleiterrippen (711), während die zweiten Seitenwände unbedeckt belassen werden, und anschließendes Füllen der Spalte zwischen den Schichten des ersten Metalls und den zweiten Seitenwänden mit einem zweiten Metall, das von dem ersten Metall verschieden ist, ausgebildet werden.

14. Verfahren nach einem der Ansprüche 1 - 13, wobei das Verfahren ein Aufbauen - auf dem gleichen Substrat - von wenigstens zwei anisotropen mehrschichtigen Strukturen (518 - 522) zum Ausbilden elektromotorischer Kräfte und ein elektrisches Verbinden der wenigstens zwei anisotropen mehrschichtigen Strukturen miteinander umfasst.

15. Verfahren nach Anspruch 14, wobei die Halbleiterrippen der wenigstens zwei anisotropen mehrschichtigen Strukturen (518 - 522) durch Ausbilden zueinander paralleler erster Nuten mit schrägen Seitenwänden und durch Ausbilden zueinander paralleler zweiter Nuten (524) senkrecht zu den ersten Nuten hergestellt werden, wobei die zweiten Nuten benachbarte der anisotropen mehrschichtigen Strukturen voneinander trennen.

## Revendications

1. Procédé de fabrication d'un capteur de flux thermique à gradient, **caractérisé en ce que** ce procédé comprend :
- le dépôt (101) d'une couche semi-conductrice (210) sur une surface planaire,
- l'enlèvement (102) de matériau de la couche semi-conductrice de manière à former des crêtes semi-conductrices parallèles (211, 311, 411, 611, 711), les crêtes semi-conductrices étant séparées les unes des autres et comportant des premières parois latérales qui sont obliques par rapport à la surface planaire et tournées dans un premier sens et des secondes parois latérales tournées dans un second sens différent du premier sens, et ensuite
- le remplissage (103) d'un intervalle entre des crêtes adjacentes parmi les crêtes semi-conductrices avec un ou plusieurs matériaux comprenant du métal de manière à ce que i) des jonctions de contact semi-conductrice de métal soient formées sur au moins les premières parois latérales des crêtes semi-conductrices et ii) des matériaux de charge d'intervalle (230, 630, 730) constitué par le ou les plusieurs matériaux et situés dans des intervalles différents parmi les intervalles soient séparés les uns des autres, de sorte que les métaux des matériaux de charge d'intervalle situés dans différents intervalles parmi les intervalles soient exempts de contact métallique les uns avec les autres,
les crêtes semi-conductrices et les matériaux de charge d'intervalle constituant une structure multicouche anisotrope pour générer une force électromotrice dans un sens perpendiculaire aux arêtes semi-conductrices et parallèle à la surface planaire en réaction à un flux thermique à travers la structure multicouche anisotrope dans un sens perpendiculaire à la surface planaire.

2. Procédé selon la revendication 1, dans lequel la couche semi-conductrice est déposée sur un substrat comportant la surface planaire.

3. Procédé selon la revendication 1, le procédé comprenant le dépôt d'une couche isolante électriquement (214) sur un substrat (215), et la couche semi-conductrice étant déposée sur la couche isolante électriquement comportant la surface planaire.

4. Procédé selon l'une quelconque des revendications 1 à 3, le procédé comprenant en outre le dépôt d'une couche isolante électriquement (217) sur le dessus de la structure multicouche anisotrope.

5. Procédé selon l'une quelconque des revendications 1 à 4, dans lequel les matériaux de charge d'intervalle (230) sont formés en :
- déposant (103a) des couches métalliques (212, 312, 412) sur les premières parois latérales des arêtes semi-conductrices tout en laissant les secondes parois latérales non couvertes, les couches métalliques étant séparées les unes des autres, et ensuite en
- remplissant (103b) les intervalles avec du matériau semi-conducteur constituant des matériaux de charge semi-conducteurs (213) de manière à ce que les matériaux de charge semi-conducteurs situés dans des intervalles différents parmi les intervalles soient séparés les uns des autres.

6. Procédé selon la revendication 5, dans lequel les matériaux de charge semi-conducteurs (213) sont formés en déposant une couche (216) du matériau semi-conducteur sur une structure comprenant les arêtes semi-conductrices et les couches métalliques et en enlevant du matériau de la couche de matériau semi-conducteur.

7. Procédé selon la revendication 5 ou 6, dans lequel les arêtes semi-conductrices (311) ont des surfaces supérieures sensiblement plates, et les couches métalliques (312) sont disposés de manière à couvrir les premières parois latérales des arêtes semi-conductrices et au moins partiellement les surfaces supérieures sensiblement plates des arêtes semi-conductrices.

8. Procédé selon l'une quelconque des revendications 5 à 7, dans lequel la couche métallique (312) de chaque arrête semi-conductrice est déposée de manière à être en contact avec une base d'une arrête semi-conductrice voisine.

9. Procédé selon l'une quelconque des revendications 5 à 8, dans lequel les arêtes semi-conductrices sont formées en enlevant du matériau de la couche semi-conductrice avec une technique d'attaque humide.

10. Procédé selon l'une quelconque des revendications 5 à 9, dans lequel :
- les couches métalliques sont composées d'un des métaux suivants : aluminium, cuivre, molybdène, constantan, nichrome,
- les matériaux de charge semi-conducteurs sont composés de silicone dopé n ou de silicone dopé p ou de silicone épitaxial ou de silicone polycristallin, et
- les arêtes semi-conductrices sont composées de silicone dopé n ou de silicone dopé p.

11. Procédé selon l'une quelconque des revendications 5 à 10, dans lequel les arêtes semi-conductrices matériaux de charge semi-conducteurs sont composés du même matériau.

12. Procédé selon l'une quelconque des revendications 1 à 3, dans lequel les secondes parois latérales des arêtes semi-conductrices (611) sont substantiellement perpendiculaires à la surface planaire, et les matériaux de charge d'intervalle (630) sont formés en remplissant les intervalles entre des arêtes adjacentes parmi les arêtes semi-conductrices avec du métal.

13. Procédé selon l'une quelconque des revendications 1 à 3, dans lequel les matériaux de charge d'intervalle (730) sont formés en posant des couches (731) de premier métal sur les premières parois latérales des arêtes semi-conductrices (711) tout en laissant les secondes parois latérales non couvertes et ensuite en remplissant les intervalles entre les couches de premier métal et les secondes parois latérales d'un second métal différent du premier métal.

14. Procédé selon l'une quelconque des revendications 1 à 13, ce procédé comprenant la réalisation, sur un substrat, d'au moins deux structures multicouches anisotropes (518 à 522) pour générer des forces électromotrices, et la connexion des au moins deux structures multicouches anisotropes électriquement l'une à l'autre.

15. Procédé selon la revendication 14, dans lequel les arêtes semi-conductrices des au moins deux structures multicouches anisotropes (518 à 522) sont réalisées en formant des premières gorges mutuellement parallèles ayant des parois latérales obliques et en formant des secondes gorges mutuellement parallèles (524) perpendiculaires aux premières gorges, les secondes gorges séparant les structures adjacentes parmi les structures multicouches anisotropes l'une de l'autre.
